Europäisches Patentamt

European Patent Office

Office européen des brevets

(11) Publication number: **0 118 576**
**B1**

(12) **EUROPEAN PATENT SPECIFICATION**

(45) Date of publication of patent specification: **02.12.87**

(21) Application number: **83102419.5**

(22) Date of filing: **11.03.83**

(51) Int. Cl.⁴: **C 23 C 28/00,** C 23 C 14/04,
H 01 L 21/00

(54) Method for forming thin films.

(43) Date of publication of application:
**19.09.84 Bulletin 84/38**

(45) Publication of the grant of the patent:
**02.12.87 Bulletin 87/49**

(84) Designated Contracting States:
**DE FR**

(56) References cited:
**EP-A-0 023 149**
**DE-A-2 146 818**
**FR-A- 805 066**
**FR-A-1 378 052**
**FR-A-1 405 134**
**FR-A-2 369 016**
**US-A-2 676 114**
**US-A-3 510 349**

**L.I. MAISSEL et al.: "HANDBOOK OF THIN FILM
TECHNOLOGY", 1970, McGraw-Hill Book
Company, New York, USA**

(73) Proprietor: **Hitachi, Ltd.**
**5-1, Marunouchi 1-chome**
**Chiyoda-ku Tokyo 100 (JP)**

(72) Inventor: **Kubota, Hitoshi**
**701-6, Karasawa**
**Fujisawa-shi (JP)**
Inventor: **Tanaka, Minoru**
**1481-5, Kamiyabecho**
**Totsuka-ku Yokohama (JP)**
Inventor: **Aiuchi, Susumu**
**Denen-Corpo. 404 1122, Shimokuratacho**
**Totsuka-ku Yokohama (JP)**

(74) Representative: **Patentanwälte Beetz sen. -
Beetz jun. Timpe - Siegfried - Schmitt-Fumian
Steinsdorfstrasse 10
D-8000 München 22 (DE)**

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

## Description

The present invention relates to a method for forming thin films through dry process, especially, suitable for the formation of microelectronic circuits.

For example, technique has hitherto been known wherein a thin film is formed on a surface of an object through dry process such as vacuum vapor deposition, ion plating, sputtering, chemical vapor deposition or molecular beam epitaxy.

In the dry process, a mask having perforations arranged in the same pattern as that of a required thin film is disposed close to a surface of a substrate on which the thin film is to be formed, so that the thin film of the same pattern as that of the perforations can be formed on the substrate.

In the dry process, a film material moving from a material source straight-forwardly toward the substrate partly passes through the perforations of the mask and is deposited on the substrate to form a film. Consequently, the outer edge of the film formed on the substrate stands substantially vertically with respect to the substrate and the film has a rectangular configuration in longitudinal section.

An electrically conductive material is deposited in a required pattern on the substrate made of an insulating material through the dry process to form a wiring section of an electronic circuit such as an integrated circuit. Where the electrically conductive film to be formed has a complicated pattern, the required pattern is divided into a plurality of sub-patterns, sub-masks corresponding to the sub-patterns are prepared, and conductive films of the sub-patterns are sequentially formed on the substrate. When, in such a case, two conductive films which mutually cross or which are laminated are desired to be formed, a preceding conductive film formed on the substrate is partly or entirely covered with an insulating film, and a succeeding conductive film is then formed on the insulating film.

When the insulating film is so formed as to partly (or entirely) cover the preceding conductive film in the formation of the two crossing (or laminated) conductive films, a shoulder having a height equal to a thickness of the preceding conductive film is formed between a portion of the insulating film deposited on the preceding conductive film and another portion thereof deposited on the substrate. As a result, the succeeding conductive film formed on the insulating film also contains a similar shoulder.

Assume now that the preceding conductive film has a thickness $t_1$, the insulating film has a thickness $t_2$ and the succeeding conductive film formed on the insulating film has a thickness $t_3$. Then, when $t_1 > t_2$, the two crossing conductive films are short-circuited to each other. When $t_1 > t_3$, the insulating film formed on the succeeding conductive film is disconnected at the shoulder. When $t_1 = t_2 = t_3$, insulation between the two crossing conductive films becomes unstable and at the same time, electrical conduction in the succeeding conductive film formed on the insulating film becomes unstable because of a shortage of the step coverage of the conductive film. Under these conditions, required electrical characteristics cannot be obtained constantly, thus lowering the yielding rate of products. Therefore, the electrical characteristics can be stabilized and the yielding rate of products can be improved by establishing $t_1 < t_2$ and $t_1 < t_3$ among the thicknesses of the preceding conductive film, insulating film and succeeding conductive film. However, this requires that the thicknesses of the insulating film and the succeeding conductive film formed thereon be increased each portion where the two conductive films mutually cross. Accordingly, working conditions must be changed for each crossing, resulting in degraded workability.

An object of the present invention is to provide a method for forming thin films which can ensure crossing and lamination of the thin films without changing the thicknesses of the thin films sequentially formed on a substrate.

Another object of the invention is to provide a method for forming thin films which can ensure manufacture of products with stable electrical characteristics at a high yielding rate.

Still another object of the invention is to provide a method for producing a thin film structure of microelectronic circuits which can form thin films in required patterns without degrading workability.

To accomplish the above objects, according to the invention, there is provided a method for producing multiple layers, including a thin film of a desired pattern as a lower layer on a substrate, by using a mask through dry process, comprising the steps of:

placing said mask and said substrate with a predetermined distance therebetween in opposed relation with each other, said mask having an aperture pattern smaller by a pattern difference (w) than at least one dimension of said desired pattern of the thin film;

effecting a first one of multiple depositions on the substrate through said mask;

changing the relative position between the mask and the substrate, by a distance smaller than said pattern difference, in the direction of the at least one thin film pattern dimension, each time each of the multiple depositions is completed;

effecting the succeeding one of said multiple depositions on the substrate, whereby the thin film, having a substantially-tapered edge in the direction of said thin film pattern dimension, is formed by said multiple depositions; and

forming at least one layer on said thin film having a substantially-tapered edge.

Additional optional advantageous features are indicated in the subclaims.

The present invention will be apparent from the following detailed description taken in conjunction with the accompanying drawings, in which:

Fig. 1 is a front view, in longitudinal section, of a vacuum evaporator for implementation of the invention in vacuum vapor deposition;

Figs. 2A to 2E are fragmentary sectional views useful in explaining the steps of thin film formation according to the invention;

Fig. 3 is a plan view showing a thin film pattern formed according to teachings of the invention;

Fig. 4 is a sectional view taken along line IV—IV in Fig. 3;

Fig. 5A is a plan view showing another thin film pattern formed according to the invention;

Fig. 5B is a sectional view taken along line B—B in Fig. 5A;

Fig. 5C is a sectional view taken along line C—C in Fig. 5A; and

Fig. 5D is a sectional view taken along line D—D in Fig. 5A.

The invention will now be described by way of example with reference to the accompanying drawings.

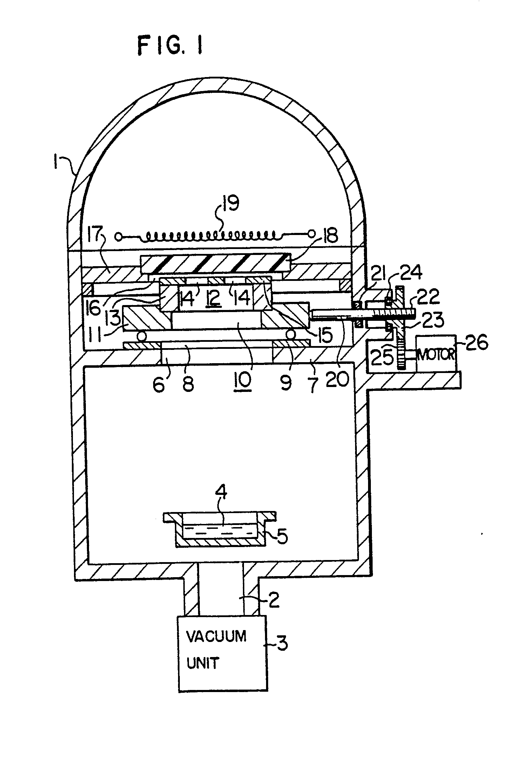

Reference should first be made to Fig. 1. A vacuum evaporator as shown therein has a vacuum vessel or chamber 1 with its inlet/outlet port 2 connected to a vacuum unit 3. When the vacuum unit 3 is operated, atmospheric pressure and evacuated pressure of a predetermined vacuum degree alternately prevail within the vacuum chamber 1. Disposed at the bottom of the vacuum chamber 1 and interiorly thereof is a crucible 5 which contains a material 4 of a film to be formed on a substrate 18. The substrate may be made of insulating material by way of example. However, semiconductor material or conductor material may also be used therefor. The crucible 5 is attached with a heater (not shown) by which the material 4 is heated to evaporate. The vacuum chamber 1 has an internal base disposed at the intermediate of the chamber and having a central opening 6. Mounted on the base 7 is a linear guide 9 having an opening 8 in communication with the opening 6. Slidably mounted on the linear guide 9 is a table 11 having an opening 10 in communication with the opening 6 and 8. Supported by the table 11 is a mask frame 13 having an opening 12 in communication with the openings 6, 8 and 10. Fixedly secured to the mask frame 13 is a mask 15 which is formed with perforations 14 arranged in the same pattern as that of thin films to be formed on the substrate 18, each perforation having a smaller size than that of each thin film. Here, each thin film is 20 to 30 μm wide and 1 to 5 μm thick, for example. The vacuum chamber 1 also has an interior substrate base 17 disposed in parallel with the base 7 and having an opening 16. The substrate base 17 carries the substrate 18 such that the substrate 18 covers the opening 16 and a surface of the substrate 18 on which the thin films are to be formed opposes the mask 15 at a predetermined spacing. Above the substrate 18 is disposed a heater 19 for heating the substrate 18. The heater 19 is connected to a power supply not shown. The table 11 is biased by a spring not shown so as to abut against one end of a rod 20 which slidably passes through the side wall of the vacuum chamber 1. An O-ring 21 for airtight sealing is applied between the vacuum chamber 1 and rod 20. A portion of the rod 20 extending exteriorly of the vacuum chamber 1 is threaded as designated at 22 and grooved with an axial channel (not shown). A member (not shown) projecting from the outer wall of the vacuum chamber 1 slidably fits in the channel to prevent the rod 20 from being rotated. A gear 23 having an outer gearing and an inner axial gearing which is in mesh with the threading 22 is rotatably supported through a bearing 24 exteriorly of the vacuum chamber 1. A gear 25 in mesh with the outer gearing of the gear 23 is supported by a motor 26 which is fixed to an outer support of chamber 1 as shown in Fig. 1. Used as the motor 26 is a control motor incorporating a known speed reduction mechanism. The rod 20, gears 23 and 25 and motor 26 constitute a drive unit for the table 11. A usual thickness monitor is provided in the chamber.

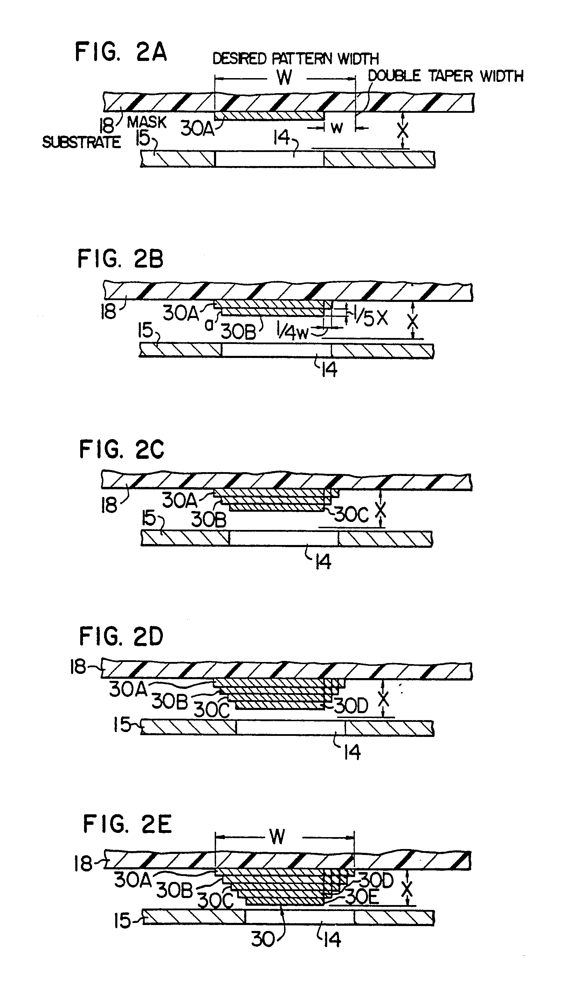

With the above construction, description will be made of the case where each thin film is produced by vapor deposition with the relative position between the mask and the substrate being shifted five times during the deposition. The mask 15 is placed on the table 11 which is positioned at a start position, and the substrate 18 is brought on the substrate base 17. Thereafter, the vacuum unit 3 is operated to evacuate the interior of the vacuum chamber 1 while heating the substrate 18 by means of the heater 19. When the interior of the chamber 1 is evacuated to a predetermined vacuum degree, the crucible 5 is heated to evaporate the material 4 contained in the crucible 5. Vaporized material from the crucible 5 passes through the openings 6, 8, 10, 12 and 14 and is deposited on the substrate 18 as shown in Fig. 2A to form a sub-film 30A. The vaporized material is mainly deposited on the inner wall of the vacuum chamber 1 and the bottom and side surfaces of the base 7, table 11, mask frame 13 and mask 15, and only a portion of the vaporized material having passed through the openings 14 is deposited on the substrate 18. In this manner, when the sub-film 30A reaches a thickness which is 1/5 (0.2 μm) of a thickness X (e.g. 1 μm) required for a conductive film and a width which is smaller than an ultimate width W by a half taper width w for example, when the taper angle is 45°, w=2 μm, the motor 26 is operated to move the table 11 and consequently the mask 15 by 1/4 w relative to the substrate. Under this condition, a second sub-film 30B is formed as shown in Fig. 2B. As a result, multishoulders *a* each having a height 1/5 X and a width 1/4 w are formed on opposite sides of the thin films 30A and 30B formed on the substrate 18 in the direction of mask shifting. Thereafter, sub-films 30C, 30D and 30E are sequentially formed on the substrate 18, thereby obtaining a substantially-tapered conductive film 30 of the required thickness X and width W. Instead, a pattern of thin film 30 with stepped outer edges may be produced by vapor deposition with the relative motion between the mask and the substrate being carried out in the range w. Sub-films 30A—30E are continuously and integrally formed of the same material as a single layer 30 but not of a multi-layer structure, in the embodiments.

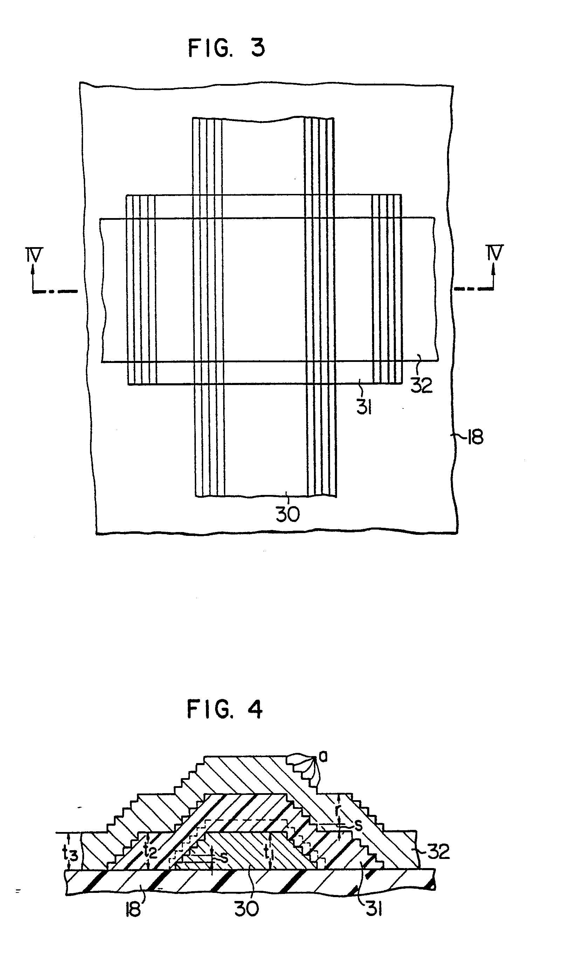

An insulating film 31 is formed on the thus formed preceding conductive film 30, and a succeeding conductive film is formed on the insulating film to complete a pattern structure as shown in Figs. 3 and 4.

Thus, in the pattern structure of Figs. 3 and 4, the preceding conductive film 30 is first formed on the substrate 18 through the steps of Figs. 2A to 2E, the insulating film 31 is then formed on the conductive film 30 through similar steps to partly cover the film 30, and finally, a succeeding conductive film 32 is formed on the insulating film 31 to extend thereacross. In the above process, it is not always necessary to form the conductive film 32 through the steps of Figs. 2A to 2E but the film 32 may be formed to the ultimate thickness through one step of vapor deposition without the shifting of the mask or the substrate.

The conductive film 32 has, at the shoulders $a$, a bridging $r$ which is a difference between the thickness $t_3$ of conductive film 32 and a height S of the shoulder. For example, where the conductive film 30 is formed of five layers each having a thickness which is 1/5 of the thickness $t_1$ of film 30 and the insulating film 31 is uniformly formed thereon to the thickness $t_2$, the height in the preceding conductive film 30 is equal to that in the succeeding conductive film 32. Consequently, the bridging $r$ in the conductive film 32 is expressed as,

$$r=t_3-S=t_3-1/5\ t_3=4/5\ t_3 \ldots \quad (1),$$

thus ensuring the bridging $r$ which amounts up to 80% of the thickness $t_3$ of conductive film 32. This holds true for insulating film 31.

It is not always necessary that the thickness of the insulating film 31 and the conductive film 30 be equal but essentially, the thickness $t_2$ of the overlying insulating film 31 must be larger then the height as shown at dotted lines in Fig. 4. Where the insulating film 31 is thin or the entire conductive film 32 is formed on the insulating film 31, the insulating film 31 may be formed through one step of vapor deposition.

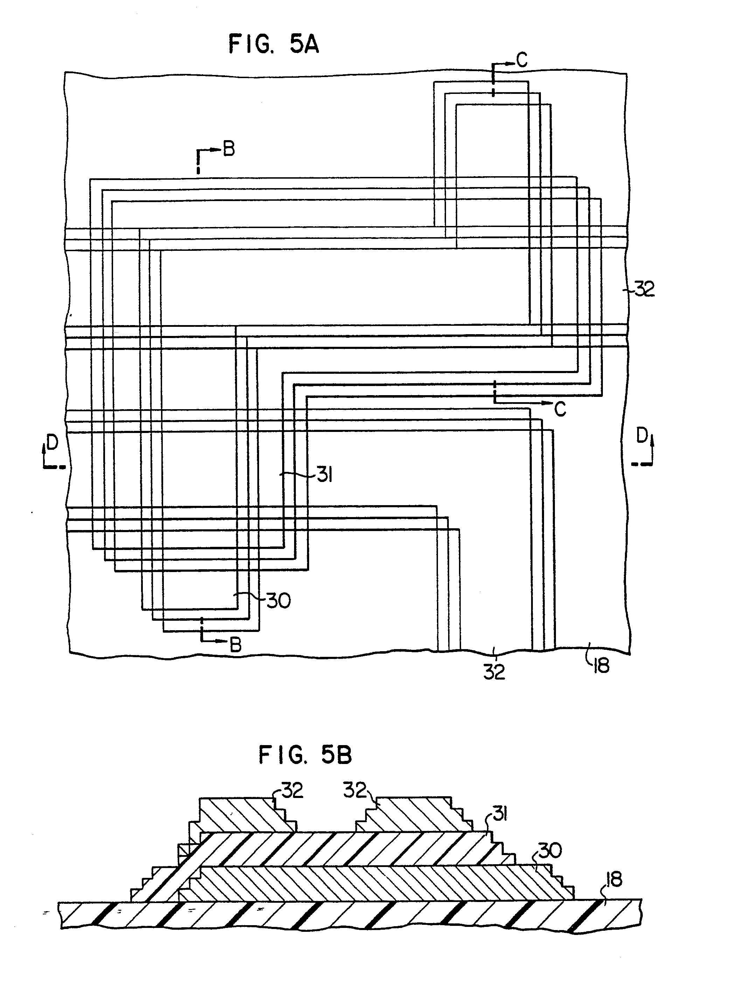

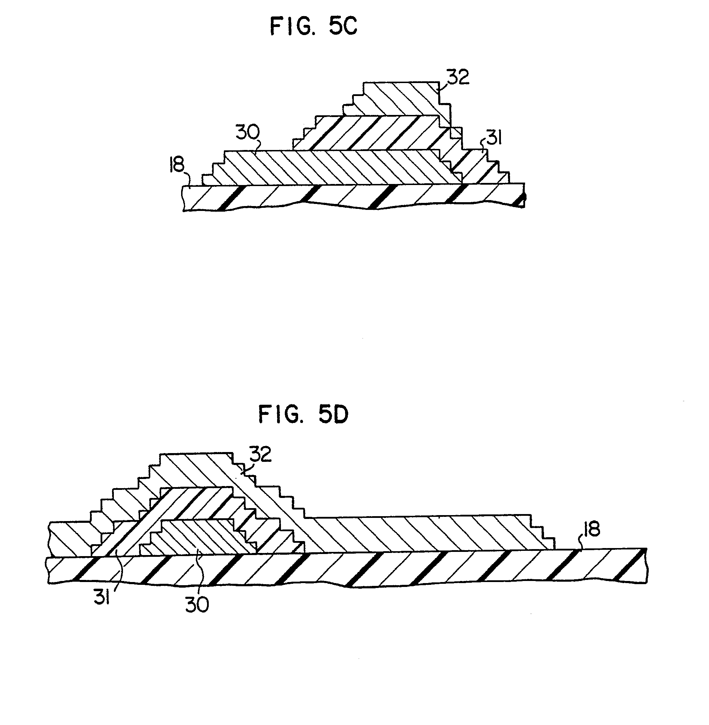

Referring now to Figs. 5A to 5D, there is shown another thin film pattern structure wherein the relative movement between the mask 15 and the substrate 18, though effected in one direction in the steps of Figs. 2A to 2E, is carried out in two directions to sequentially form a conductive film 30, an insulating film 31 and a conductive film 32 on the substrate 18.

With this construction, the conductive film 32 formed on the insulating film 31 can extend across the insulating film 31 in desired directions, thereby improving freedom of circuit design to make it possible to form more complicated circuits.

For the relative movement of mask 15 and substrate 18 in the two directions, two drive units operable in these direction may be used. The desired pattern width W is usually 20 to 30 μm in the fabrication of hybrid components and the taper width w/2 is generally determined to make a taper angle of up to 70° between the substrate plane and the thickness of each tapered film. The spacing or gap between the mask and the substrate is to be held at most about 100 μm for practical use. According to the invention, the step coverage of a conductor circuit in a multi-layered circuit structure can be improved up to at least 80% with taper control.

**Claims**

1. A method for forming multiple layers, including a thin film of a desired pattern as a lower layer on a substrate, by using a mask through dry process, comprising the steps of:

placing said mask and said substrate with a predetermined distance therebetween in opposed relation with each other, said mask having an aperture pattern smaller by a pattern difference (w) than at least one dimension of said desired pattern of the thin film;

effecting a first one of multiple depositions on the substrate through said mask;

changing the relative position between the mask and the substrate, by a distance smaller than said pattern difference, in the direction of the at least one thin film pattern dimension, each time each of the multiple depositions is completed;

effecting the succeeding one of said multiple depositions on the substrate, whereby the thin film, having a substantially-tapered edge in the direction of said thin film pattern dimension, is formed by said multiple depositions; and

forming at least one layer on said thin film having a substantially-tapered edge.

2. A method according to claim 1, wherein each of the succeeding ones of the multiple depositions is performed during changing the relative position between the mask and substrate, whereby the thin film having a stepped edge in the direction of the thin film pattern dimension is formed.

3. A method according to claim 1, wherein each of the succeeding ones of the multiple depositions is performed after changing the relative position between the mask and substrate, whereby the thin film having a stepped edge in the direction of the thin film pattern dimension is formed.

4. A method according to claim 3, wherein the relative positioning is changed to provide n total multiple depositions, with the relative position changed by a distance

$$\left(\frac{1}{n-1}\right)(w)$$

for each deposition.

5. A method according to claim 4, wherein the thin film has a total thickness (X), with the partial thickness formed at each of said multiple depositions being

$$\left(\frac{1}{n}\right) (X).$$

6. A method according to claim 1, wherein the multiple depositions are performed by vapor deposition.

7. A method according to claim 1, wherein the taper angle between the substrate plane and the formed thin film is at most 70°.

8. A method according to claim 7, wherein the predetermined distance between the mask and the substrate is at most about 100 µm.

9. A method according to claim 1, wherein the mask has an aperture pattern smaller by pattern differences than two dimensions of said desired pattern of the thin film, and wherein the relative position between the mask and substrate is changed in the directions of each of said two dimensions, whereby the thin film is tapered in two directions.

10. A method according to claim 1, wherein two layers are formed on said substantially-tapered, vapor deposited thin film, with a first layer being formed on said substantially-tapered vapor deposited film and a second layer being formed on said first layer.

11. A method according to claim 10, wherein said substantially-tapered, vapor-deposited thin film is made of an electrically conductive material, said first layer is made of an insulating material, and said second layer is made of an electrically conductive material.

12. A method according to claim 11, wherein the first layer is also made by said using a mask, said carrying out a relative motion and said forming a thin film.

**Patentansprüche**

1. Verfahren zur Bildung mehrfacher Schichten einschließlich einer Dünnschicht eines gewünschten Musters als einer unteren Schicht auf einem Substrat unter Verwendung einer Maske durch ein Trockenverfahren, gekennzeichnet durch die Schritte:

Anordnen der Maske und des Substrats mit einem vorbestimmten Abstand dazwischen in Gegenüberstellung zueinander, wobei die Maske ein Öffnungsmuster hat, das um eine Musterunterschied (w) kleiner als wenigstens eine Abmessung des gewünschten Musters der Dünnschicht ist;

Vornehmen einer ersten von mehrfachen Abscheidungen auf dem Substrat durch die Maske;

Ändern der Relativlage zwischen der Maske und dem Substrat um einen kleineren Abstand als den Musterunterschied in der Richtung der wenigstens einen Dünnschichtmuster - Abmessung jedesmal, wenn jede der mehrfachen Abscheidungen vollendet ist;

Vornehmen der folgenden der mehrfachen Abscheidungen auf den Substraten, wodurch die Dünnschicht mit einer in der Richtung der Dünnschichtmuster-Abmessung im wesentlichen abgeschrägten Kante durch die mehrfachen Abscheidungen gebildet wird; und

Bilden wenigstens einer im wesentlichen abgeschrägten Kante.

2. Verfahren nach Anspruch 1, wobei jede der folgenden oder mehrfachen Abscheidungen während des Änderns der Relativlage zwischen der Maske und dem Substrat vorgenommen wird, wodurch die Dünnschicht mit einer in der Richtung der Dünnschichtmuster-Abmessung abgestuften Kante gebildet wird.

3. Verfahren nach Anspruch 1, wobei die folgenden der mehrfachen Abscheidungen nach dem Ändern der Relativlage zwischen der Maske und dem Substrat vorgenommen werden, wodurch die Dünnschicht mit einer in der Richtung der Dünnschichtmuster-Abmessung abgestuften Kante gebildet wird.

4. Verfahren nach Anspruch 3, wobei die Relativlageeinstellung zur Vornahme von insgesamt n mehrfachen Abscheidungen unter Änderung der Relativlage um einen Abstand von

$$\left(\frac{1}{n-1}\right) (w)$$

für jede Abscheidung geändert wird.

5. Verfahren nach Anspruch 4, wobei die Dünnschicht eine Gesamtdicke (X) hat und die bei jeder der mahrfachen Abscheidungen gebildete Teildicke

$$\left(\frac{1}{n}\right) (X)$$

ist.

6. Verfahren nach Anspruch 1, wobei die mehrfachen Abscheidungen durch Dampfabscheidung vorgenommen werden.

7. Verfahren nach Anspruch 1, wobei der Abschrägungswinkel zwischen der Substratebene und der gebildeten Dünnschicht höchstens 70° ist.

8. Verfahren nach Anspruch 7, wobei der vorbestimmte Abstand zwischen der Maske und dem Substrat höchstens etwa 100 µm ist.

9. Verfahren nach Anspruch 1, wobei die Maske ein Öffnungsmuster hat, das um Musterunterschiede kleiner als zwei Abmessungen des gewünschten Musters der Dünnschicht ist, und wobei die Relativlage zwischen der Maske und dem Substrat in den Richtungen jeder der zwei Abmessungen geändert wird, wodurch die Dünnschicht in zwei Richtungen abgeschrägt wird.

10. Verfahren nach Anspruch 1, wobei zwei Schichten auf der im wesentlichen abgeschrägten, dampfabgeschiedenen Dünnschicht gebildet werden, indem eine erste Schicht auf der im wesentlichen abgeschrägten, dampfabgeschiedenen Schicht gebildet und eine zweite Schicht auf der ersten Schicht gebildet wird.

11. Verfahren nach Anspruch 10, wobei die im wesentlichen abgeschrägte dampfabgeschiedene Dünnschicht aus einem elektrisch leitenden Material hergestellt, die erste Schicht aus einem Isoliermaterial hergestellt und die zweite Schicht aus einem elektrisch leitenden Material hergestellt werden.

12. Verfahren nach Anspruch 11, wobei die erste Schicht auch durch die Verwendung einer Maske, die Durchführung einer Relativbewegung und die Bildung einer Dünnschicht hergestellt wird.

**Revendications**

1. Procédé pour former des couches multiples, incluant une pellicule mince possédant une configuration désirée, en tant que couche inférieure sur un substrat, grâce à l'utilisation d'un masque, au moyen d'un procédé à sec, comprenant les étapes consistant à:

placer ledit masque et ledit substrat en vis-à-vis à une distance réciproque prédéterminée, ledit masque possédant une configuration d'ouverture possédant une dimension inférieure d'une différence de configuration (w) à au moins une dimension de ladite configuration désirée de la pellicule mince;

réaliser un premier dépôt faisant partie de dépôts multiples sur le substrat, moyennant l'interposition dudit masque, modifier la position relative entre le masque et le substrat, sur une distance inférieure à ladite différence de configuration, dans la direction d'au moins une dimension de la configuration de la pellicule mince, chaque fois que chacun des dépôts multiples est achevé;

exécuter le dépôt suivant faisant partie desdits dépôts multiples, sur le substrat, ce qui a pour effet que la pellicule mince, qui possède un bord de forme sensiblement inclinée dans la direction de ladite dimension de la configuration de la pellicule mince, est formée au moyen desdits dépôts multiples; et

former au moins une couche sur ladite pellicule mince possédant un bord de forme sensiblement inclinée.

2. Procédé selon la revendication 1, selon lequel chacun des dépôts successifs faisant partie des dépôts multiples est réalisé pendant la modification de la position relative entre le masque et le substrat, ce qui entraîne la formation de la pellicule mince possédant un bord étagé dans la direction de la dimension de la configuration de la pellicule mince.

3. Procédé suivant la revendication 1, selon lequel chacun des dépôts successifs faisant partie des dépôts multiples est exécute après modification de la position relative entre le masque et le substrat, ce qui entraîne la formation de la pellicule mince possédant un bord étagé dans la direction de la dimension de la configuration de la pellicule mince.

4. Procédé selon la revendication 3, selon lequel on modifie le positionnement relatif pour obtenir n dépôts multiples totaux, la position relative étant modifiée d'une distance

$$\left(\frac{1}{n-1}\right) (w)$$

pour chaque dépôt.

5. Procédé selon la revendication 4, selon lequel la pellicule mince possède une épaisseur totale (X), l'épaisseur partielle formée lors de chacun desdits dépôts multiples étant

$$\left(\frac{1}{n}\right) (X)$$

6. Procédé selon la revendication 1, selon lequel les dépôts multiples sont exécutés au moyen d'un dépôt en phase vapeur.

7. Procédé selon la revendication 1, selon lequel l'angle d'inclinaison entre le substrat plan et la pellicule mince formée est égale au maximum à 70°.

8. Procédé selon la revendication 7, selon lequel la distance prédéterminée entre le masque et le substrat est égale au maximum à environ 100 µm.

9. Procédé selon la revendication 1, selon lequel le masque possède une configuration d'ouverture dont les dimensions sont inférieures, de différences de configuration, à deux dimensions de ladite configuration désirée de la pellicule mince, et selon lequel la position relative entre le masque et le substrat est modifiée dans les directions de chacune desdites deux dimensions, ce qui a pour effet que la pellicule mince possède une forme inclinée dans deux directions.

10. Procédé selon la revendication 1, selon lequel deux couches sont formées sur ladite pellicule mince déposée en phase vapeur et de forme sensiblement inclinée, une première couche étant formée sur ladite pellicule déposée en phase vapeur, de forme sensiblement inclinée et une seconde couchant étant formée sur ladite première couche.

11. Procédé selon la revendication 10, selon lequel ladite pellicule déposée en phase vapeur, de forme sensiblement inclinée est réalisé en un matériau électriquement conducteur, ladite première couche est réalisée en un matériau isolant et que ladite seconde couche est réalisée en un matériau électriquement conducteur.

12. Procédé selon la revendication 11, selon lequel la première couche est également réalisée moyennant ladite utilisation d'un masque, ladite exécution d'un déplacement relatif et ladite formation d'une pellicule mince.

# FIG. I

## FIG. 2A

DESIRED PATTERN WIDTH

W

DOUBLE TAPER WIDTH

18 — MASK    30A    14    w    X

SUBSTRATE    15

## FIG. 2B

18    30A    a    30B    1/4w    1/5X    X    15    14

## FIG. 2C

18    30A    30B    30C    X    15    14

## FIG. 2D

18    30A    30B    30C    30D    X    15    14

## FIG. 2E

W

18    30A    30B    30C    30D    30E    X    15    30    14

## FIG. 3

## FIG. 4

## FIG. 5A

## FIG. 5B

4

## FIG. 5C

## FIG. 5D